# EUROPEAN PATENT APPLICATION

(11) **EP 0 730 317 A1**
(43) Date of publication of application: **04.09.1996**
(21) Application number: 96301010.3
(22) Date of filing: 14.02.1996
(51) Int. Cl.: H01P 1/04

(54) **Structures for filters and/or resonators**

(30) Priority: 28.02.1995 GB 9503954
(71) Applicant: PLESSEY SEMICONDUCTORS LIMITED, Swindon, Wiltshire SN2 2QW (GB)
(72) Inventor: Pedder, David John, Long Compton, Warwickshire, CV36 5LB (GB); Jones, Stephen Morgan, Swindon, Wiltshire, SN5 9LT (GB)
(74) Representative: Hoste, Colin Francis

(57) **Abstract**

A structure forming a resonator or a filter for a multichip module or surface mount assembly comprises a chip of a high dielectric constant ceramic material such as lead-barium-neodymium-titanate or zirconium-titanium-stannate with a ground plane on one major surface and a stripline or coplanar waveguide metallisation pattern on the other major surface forming for example one or more short lengths of transmission line. The metallisation pattern is arranged to be connected to conductors on the multichip module or surface mount substrate by flip chip solder bonding.

## Description

The present invention relates to structures for filters and/or resonators, and in particular although not exclusively to such structures designed for flip chip solder bonding.

Modern microelectronic systems demand ever greater levels of integration and the use of component construction techniques that provide cost effective, highly compact assemblies and sub-assemblies. The demands are particularly strong in the area of portable electronic products where assembly size, weight, power consumption and cost are critical. The emergence of advanced multichip module (MCM) and surface mount (SMT) circuit construction techniques is leading to a significant reduction in circuit area for the implementation of a given circuit function. However currently available ceramic filter and resonator components for the construction of microwave and radio circuits in such portable products are physically bulky, occupying significant card area and commonly dominating the height of the overall assembly. These components are currently not compatible with MCM circuit constructions. Available resonator and filter components are also relatively costly.

According to the present invention a structure for a filter and/or a resonator for attachment by flip chip solder bonding to conductors on a surface of a substrate comprises a chip of electrically insulating ceramic material having upper and lower major surfaces, a pattern of thin film metallisation on the lower major surface of said chip, said pattern including bonding pads for said solder bonding, and a continuous ground plane metallisation on the upper major surface of said chip.

Preferably the pattern of metallisation on the lower major surface of the chip includes a perimeter metallisation which is connected to said ground plane metallisation and by way of which said ground plane metallisation is connected to at least one conductor on the substrate. The ceramic material of said chip may be lead-barium-neodymium-titanate or zirconium-titanium-stannate.

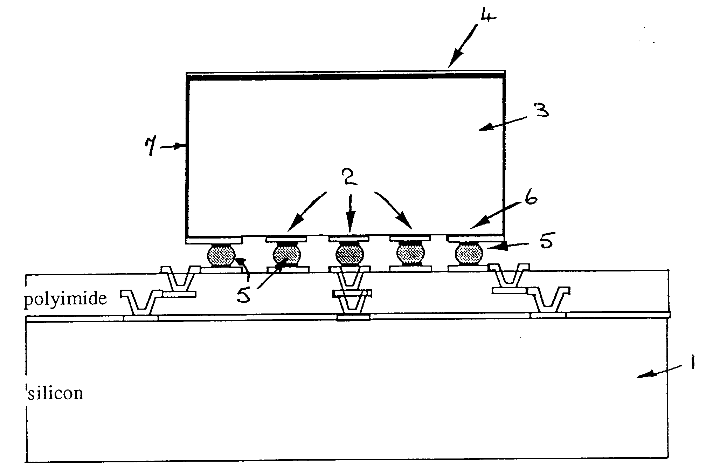

A structure in accordance with the invention will now be described by way of example with reference to the accompanying drawing, which shows the structure diagrammatically in section.

Referring to the drawing, the structure, which is designed for flip chip bonding on a multichip module (MCM) circuit assembly 1, comprises thin film metallisation patterns 2 on the lower surface of a chip 3 of a high dielectric constant microwave ceramic material and a continuous, ground plane metallisation 4 on the upper surface. Connections 5 between the lower metallisation patterns 2 and the remainder of the circuitry on the MCM assembly 1 are made by flip chip solder bonding. The perimeter 6 of the lower surface metallisation pattern may be grounded to isolate the filter or resonator structure and to provide coupling to the upper metallisation plane 4. Suitable high dielectric constant microwave ceramic materials include lead-barium-neodymium-titanate and zirconium-titanium-stannate.

The thin film metallisation patterns 2 on the lower surface of the ceramic chip 3 define the resonator or filter structure itself. Short lengths of surface microstrip or coplanar transmission line (nλ/4) may be employed to provide a suitable resonator component. In a surface microstrip line the upper chip metallisation layer 4 provides the ground reference plane whereas adjacent lower metallisation areas 2 provides the ground plane for a coplanar structure. In either structure the external connections to the resonator and to the lower ground plane are made by means of flip chip solder bonds 5. The use of this bonding technology is fundamental to the realisation of these components, since it provides the required small bond area, low bond parasitics and freedom of bond location to connections distributed over the area of the lower chip surface.

Filters may be defined using coupled resonator structures of various types, again employing microstrip or coplanar transmission line elements, with or without capacitive loading. Sets of two or more coupled lines may be used, for example, in which the line lengths are defined at λ/4 or λ/2 respectively. These line structures may also be folded upon themselves to minimise their length.
A non-exhaustive listing of potential filter structure categories is given below.

| **Transmission Line Type** | **Filter Structure** |
|---|---|
| | |
| Microstrip | Comb-line |
| | Interdigital |
| | Capacitive, end coupled λ/2 resonators |
| | |
| | Parallel coupled λ/2 resonators |
| | Hairpin |
| | |
| Coplanar waveguide | Capacitive, end coupled λ/2 resonators |
| | Series/Shunt λ/4 resonators |
| | |
| Mixed, Slotline/Coplanar waveguide | End coupled λ/2 resonators |

The metallisation material employed, its thickness and pattern dimensions are selected to provide the required resonator or filter response. The quality factor of the resulting structure will be significantly influenced by the metallisation losses. For this reason microwave ceramic materials of the highest possible dielectric constant that is consistent with low dielectric loss and low temperature coefficient of capacitance are selected. This minimises the λ/4 or λ/2 equivalent line length and hence the associated metallisation losses. Low resistivity metallisation materials such as aluminium or copper may be employed at typical thicknesses from 2 to 10 micrometres. A very thin layer (10 to 100 nanometres) of a reactive metallisation material, such as titanium or chromium, may be employed to provide high adhesion between the low resistivity metallisation and the microwave ceramic surface if required. Standard metallisation deposition and patterning techniques, including sputter deposition, electrodeposition, wet and dry etching may be employed, depending on the detailed materials selection. The patterning techniques employed are selected to provide at least 1 micrometre accuracy per feature.

Minor variability in the dielectric constant of the microwave ceramic material employed may be compensated in these resonator and filter structures by designing them to be compatible with rf-on-wafer probe testing and employing active laser trimming of the structure (line length or area adjustment) to conduct any necessary precision adjustments.

A continuous, ground plane metallisation is provided on the upper surface of the microwave ceramic chip. This layer may employ the same metallisation materials and processes as are used on the lower, patterned metallisation surface. Through-ceramic vias are not provided in these structures in order to minimise cost, but chip sidewall metallisation 7 (a deposited layer or painted-on metallic ink) may be employed to make a direct connection between the upper ground plane 4 and the grounded perimeter 6 of the lower surface if required. The inherent capacitance between the upper ground plane 4 and the grounded perimeter 6 of the lower surface may provide sufficient capacitive coupling without the need for a direct connection. The perimeter 6 of the lower metallisation region is grounded both to isolate the filter or resonator structure and to provide coupling to the upper metallisation plane 4. The presence of the upper ground plane 4, the grounded lower plane perimeter region 6 and a ground plane in the MCM substrate 1 on which the component is flip chip mounted ensures effective screening and isolation of the resonator or filter function from adjacent microwave or radio circuitry.

Lead-barium-neodymium-titanate material provides a relative dielectric constant of between 60 and 88, with a resonator quality factor of 1100 to 2000 at 3 Ghz and a zero temperature coefficient of resonant frequency over a range of compositions. The zirconium-titanium-stannate material provides a dielectric constant of 38, with a quality factor of 13000 at 3 Ghz and a zero temperature coefficient of resonant frequency over a range of compositions. The chip thickness employed may be less than or equal to that employed in the other mounted components in the assembly. For an MCM situation this would imply an upper thickness limit of 525 micrometres (i.e. one silicon IC thickness). A 2.45 GHz flip chip resonator component realised using lead-barium-neodymium-titanate material would require a resonant line 4.7 mm in length, implying a component size of approximately 1 by 5 mm, or 2 by 2.5 mm for a folded structure.

The flip chip solder bonding technique is fundamental to the realisation of these components, since it provides the required 50 to 125 micrometre bond area, low bond parasitics (below 50 pH per bond) and the freedom of bond location to connections distributed over the area of the lower chip surface. Standard flip chip solder bond materials and processes may be employed to realise the required solder bonds. These include CrCuAu solderable metallisation layers and 95Pb-5Sn (wt.%) solder for MCM applications and similar or lower melting point solders for SMT applications. Typical bond heights are 15 to 125 micrometres.

The filter and resonator structures are inherently of low cost since they employ the highest possible dielectric constant materials for minimal component area, and their fabrication involves only two lithographic process stages, the first for the patterning of the lower metallisation layers 2 and the second for the definition of the required solder bump areas. The use of ceramic materials in a wafer format together with integrated circuit-like processing techniques will also lead to inherently low manufacturing costs.

The connections on the MCM substrate 1 may be controlled impedance traces as required. The geometrical scale of MCM-D technology is considered particularly well matched for the application of the flip chip filter and resonator structures described above. Such flip chip resonator and filter components may also be employed in Ball Grid Array assemblies, where the resonator or filter component is flip chip bonded directly to appropriate metallisation patterns on the assembly surface. The ball grid array may be for a single chip or multichip module assembly. These structures may also be employed in MCM-L assemblies.

## Claims

1. A structure for a filter and/or a resonator for attachment by flip chip solder bonding to conductors on a surface of a substrate comprising a chip of electrically insulating ceramic material having upper and lower major surfaces, a pattern of thin film metallisation on the lower major surface of the chip, said pattern including bonding pads for said solder bonding, and a continuous ground plane metallisation on the upper major surface of said chip.

2. A structure in accordance with Claim 1 wherein the pattern of metallisation on the lower major surface of the chip includes a perimeter metallisation which is connected to said ground plane metallisation and by way of which said ground plane metallisation is connected to at least one conductor on the substrate.

3. A structure in accordance with Claim 2 wherein the perimeter metallisation on the lower major surface of the chip is connected to the ground plane metallisation on the upper major surface by way of an edge metallisation link.

4. A structure in accordance with Claim 3 wherein the edge metallisation link is a painted-on metallic ink.

5. A structure in accordance with Claim 1 wherein the pattern of metallisation on the lower major surface of the chip defines at least one transmission line element.

6. A structure in accordance with Claim 5 wherein the transmission line element is a microstrip line element.

7. A structure in accordance with Claim 5 wherein the transmission line element is a coplanar waveguide element.

8. A structure in accordance with Claim 1 wherein the ceramic material is of a lead-barium-neodymium-titanate composition.

9. A structure in accordance with Claim 1 wherein the ceramic material is of a zirconium-titanium-stannate composition.
